# EUROPEAN PATENT APPLICATION

(11) **EP 4 432 373 A1**
(43) Date of publication of application: **18.09.2024**
(21) Application number: 22893070.7
(22) Date of filing: 26.10.2022
(51) Int. Cl.: H01L 31/048, H01L 31/0445, H01L 27/15, H01L 31/05, H01L 31/053

(54) **PHOTOVOLTAIC SYSTEM CAPABLE OF DISPLAYING IMAGES ON FRONT**

(30) Priority: 10.11.2021 KR 20210153838
(71) Applicant: Hansol Technics Inc., Seoul 04551 (KR)
(72) Inventor: LEE, In Ho, Cheongju-si Chungcheongbuk-do 28165 (KR); LEE, Dong Gi, Yongin-si Gyeonggi-do 17003 (KR)
(74) Representative: Kuhnen & Wacker Patent- und Rechtsanwaltsbüro PartG mbB
(86) International application number: PCT/KR2022/016402
(87) International publication number: WO 2023/085647

(57) **Abstract**

The present invention discloses a photovoltaic (PV) system capable of displaying images on the front. The PV system of the present invention is configured to enable images to be displayed on the front of a PV module when the PV module is installed on a building, thereby, by efficient collection of PV energy through the PV module, securing electrical energy to increase the amount of power generation and using the secured electrical energy to display various types of images on the outside of the building.

## Description

### [Technical Field]

The present invention relates to a photovoltaic system capable of displaying images toward the front while receiving driving power by photovoltaic power generation.

### [Background Art]

New renewable energy is recognized as a clean energy source that does not cause global warming or emission of hazardous substances such as pollutants and radioactive substances and does not require a reprocessing facility or the like. New renewable energy comes from various sources such as wind, wave, solar, and geothermal heat, but solar power is most commonly used as a new renewable energy source due to being the most convenient in terms of size diversification, installation, and management thereof.

In recent years, systems such as carbon credits have been enforced around the world to reduce greenhouse gas emission, and new renewable energy has been considered more important. Accordingly, various methods for increasing the amount of power generation using new renewable energy have been tried actively. In particular, such tries have been focused on solar power due to its high convenience compared to other power generation methods, and as a result, a photovoltaic (PV) system used on a building for purposes of lighting, ventilation, and the like has been implemented conventionally.

That is, the PV system is a building exterior technology for installing a PV module on a building so that the PV module produces electricity while also serving as a building material. The PV module is used as an exterior material of a building in addition to producing electricity using PV energy and supplying the produced electricity to consumers.

Meanwhile, in some cases, the conventional PV system is applied on a wall surface or the like of a building to enable images to be displayed thereon.

However, in a case where a display device capable of displaying images is applied to the above-described PV system, since, conventionally, a PV module is disposed on the rear of a display device, which is configured to transmit PV energy therethrough to prevent a decrease in PV energy collection efficiency, in a state in which the display device is disposed on the front, there is a problem in that PV energy collection is not properly performed by the PV module.

In addition, a structure in which the PV module is disposed on the front and the display device is disposed on the rear of the PV module is not possible to be implemented on an outer wall of a building.

### [Disclosure]

### [Technical Problem]

The present invention is directed to providing a photovoltaic (PV) system capable of displaying images on the front that is configured to enable images to be displayed on the front of a PV module when the PV module is installed on a building, thereby, by efficient collection of PV energy through the PV module, securing electrical energy to increase the amount of power generation and using the secured electrical energy to display various types of images on the outside of the building.

### [Technical Solution]

The present invention provides a photovoltaic (PV) system capable of displaying images on the front, the PV system including: a module frame fixed to a building; a PV module mounted on the module frame and configured to collect PV energy and produce electricity; light emitting diode (LED) modules disposed in multiple stages at a rear of the PV module and configured to use the electricity produced by the PV module as driving power to irradiate light for an image to be displayed on a front of the PV module; a module driver configured to drive the LED modules to be turned on, turned off, or flicker; and a controller configured to output to the module driver a signal for controlling whether the electricity produced by the PV module is supplied or a driving pattern of turning-on, turning-off, or flickering of the LED modules.

Also, the PV module may include: a transparent front cover fixed to the module frame; a transparent back cover fixed to the module frame; and PV cells arranged in multiple stages while maintaining predetermined intervals therebetween for a light source outlet to be formed between the front cover and the back cover and electrically connected through a junction box and cables.

Also, a protective sheet may be laminated on each of both sides of the PV cell.

Also, the PV cell may be a single side type cell or a double side type cell.

Also, the cables connected to the junction box electrically connected to the PV cell may be connected by a cable jack.

Also, a pattern part for expansion of a reflective area and a heat dissipation area may be formed on one side of the back cover.

Also, the pattern part may consist of embossed protrusions.

Also, the pattern part may be a protruding structure bent in any one of a V-shape, an L-shape, a right-angled C-shape, and a U-shape.

Also, the LED module may include: a lamp fixer fixed to the other side of the back cover and formed in a box-shaped structure and opend in the direction of the PV module; a substrate accommodated in the lamp fixer; one or more LED devices mounted on the substrate; and a transparent cover window coupled to the opening of the lamp fixer and configured to guide light source caused by turning-on or flickering of the LED devices to be output to the outside through the back cover, the light outlet, and the front cover.

Also, the lamp fixer may be adhered and fixed to the other side of the back cover by a transparent adhesive layer formed on the transparent cover window.

Also, the transparent adhesive layer may be a silicone adhesive or an adhesive sheet.

Also, the transparent adhesive layer may be formed on the transparent cover window by a lamination technique or a hot press technique.

Also, the module driver may include at least one board structure or one or more board structures that is or are attachable to and detachable from a side portion of the module frame through a fastening member, the board structure may be molded to be waterproof and dampproof, and a driving circuit including a direct current-direct current (DC-DC) converter may be mounted on the board structure.

Also, the controller may be connected to communicate with the module driver.

In addition, a battery configured to be charged by the electricity produced by the PV module and supply driving power to the LED module and the module driver may be mounted on the module frame.

### [Advantageous Effects]

The present invention relates to a photovoltaic (PV) system capable of displaying images on the front of a PV module when the PV module is installed on a building. In this way, by efficient collection of PV energy through the PV module, electrical energy can be secured to increase the amount of power generation and the secured electrical energy can be used to display various types of images on the outside of the building.

Advantageous effects of the present invention are not limited to those mentioned above, and other unmentioned advantageous effects should be clearly understood by those of ordinary skill in the art from the claims below.

### [Description of Drawings]

FIG. 1 is a schematic block diagram of a photovoltaic (PV) system capable of displaying images on the front according to an embodiment of the present invention.
FIG. 2 is a perspective view of a structure of the PV system capable of displaying images on the front according to an embodiment of the present invention.
FIG. 3 is an exploded view of the structure of the PV system capable of displaying images on the front according to an embodiment of the present invention.
FIG. 4 is a front view of the structure of the PV system capable of displaying images on the front according to an embodiment of the present invention.
FIG. 5 is a schematic cross-sectional view of a state in which a light emitting diode (LED) module is adhered and fixed to a PV module according to an embodiment of the present invention.
FIG. 6 is a front view of a state in which an image is displayed by a single PV system according to an embodiment of the present invention.
FIG. 7 is a front view of a state in which images are displayed by a plurality of PV systems according to an embodiment of the present invention.

### [Best Mode of the Invention]

Advantages and features of the present invention and methods of achieving the same will become apparent from embodiments described in detail below with reference to the accompanying drawings. However, embodiments according to the technical spirit of the present invention are not limited to the embodiments disclosed below and may be implemented in various different forms. The embodiments herein are only provided to make the disclosure of the present invention complete and completely inform those of ordinary skill in the art to which the present invention pertains of the scope of the invention, and the embodiments according to the technical spirit of the present invention are only defined by the scope of the claims.

Terms used herein are only for describing the embodiments and are not intended to limit the present invention. In the present specification, a singular expression includes a plural expression unless the context clearly indicates otherwise.

In the present specification, terms such as "include" or "have" are intended to designate the presence of features, numbers, steps, operations, components, parts, or combinations thereof described herein and should not be understood as precluding the possibility of presence or addition of one or more other features, numbers, steps, operations, components, parts, or combinations thereof.

Also, embodiments described herein will be described with reference to cross-sectional views and/or plan views which are ideal exemplary views of the present invention. Therefore, the embodiments of the present invention are not limited to specific forms illustrated in the drawings and may also include shape changes that are necessary. For example, an area illustrated as having a right angle may have a round shape or a shape having a predetermined curvature. Therefore, areas illustrated in the drawings have schematic attributes, and shapes of the areas illustrated in the drawings are for illustrating specific shapes of areas of the system and are not intended to limit the scope of the invention.

Throughout the specification, like reference numerals refer to like components. Therefore, even when not mentioned or described with reference to the corresponding drawings, like or similar reference numerals may be described with reference to other drawings. Also, reference numerals not shown in certain drawings may be described with reference to other drawings.

Hereinafter, embodiments of the present invention will be described with reference to the accompanying drawings.

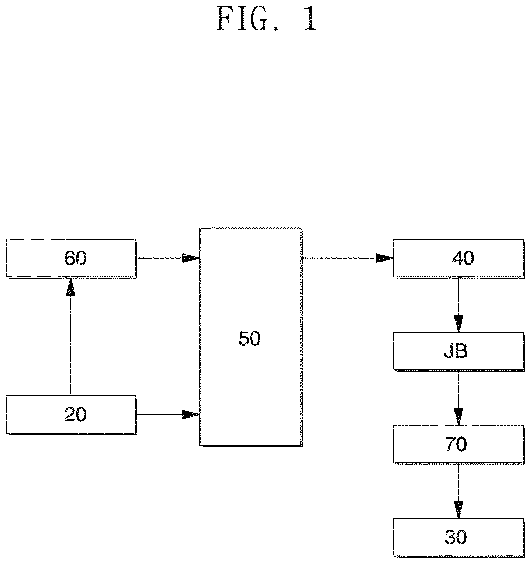

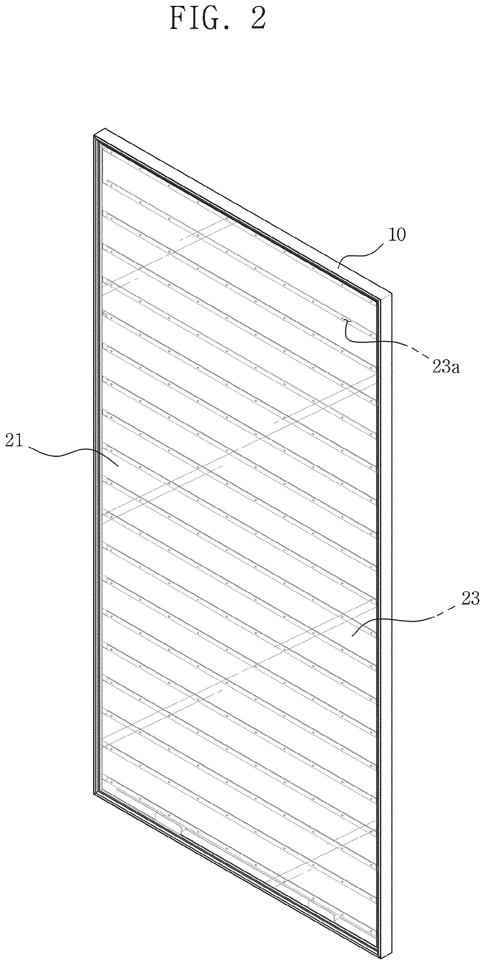

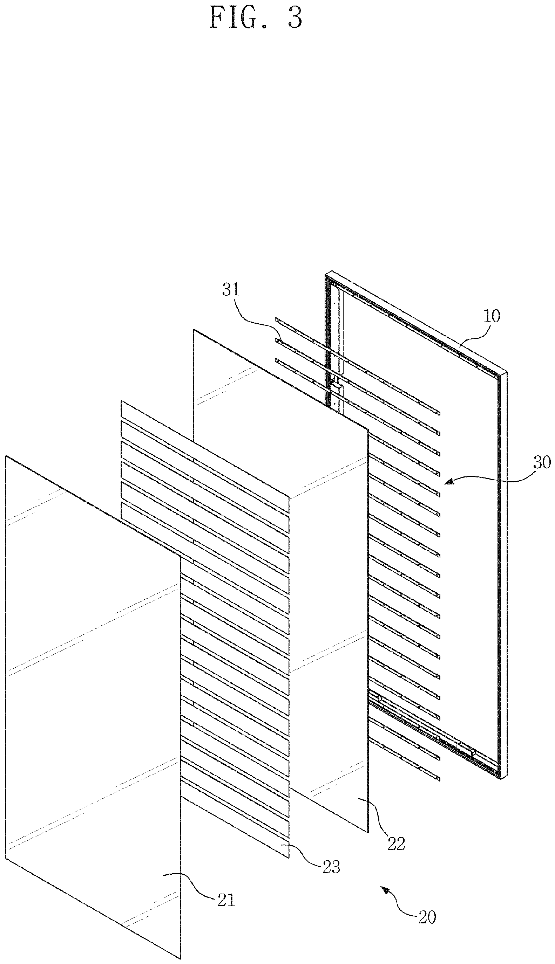

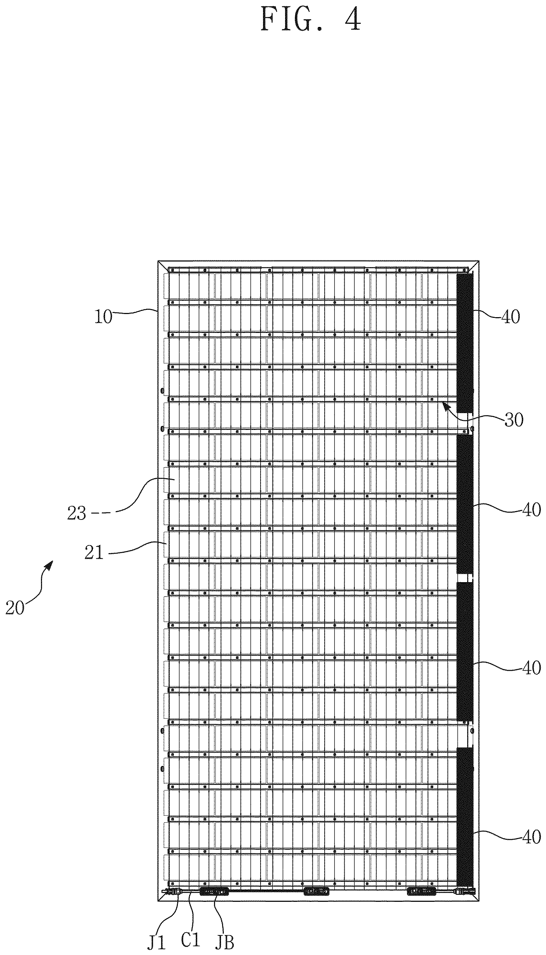

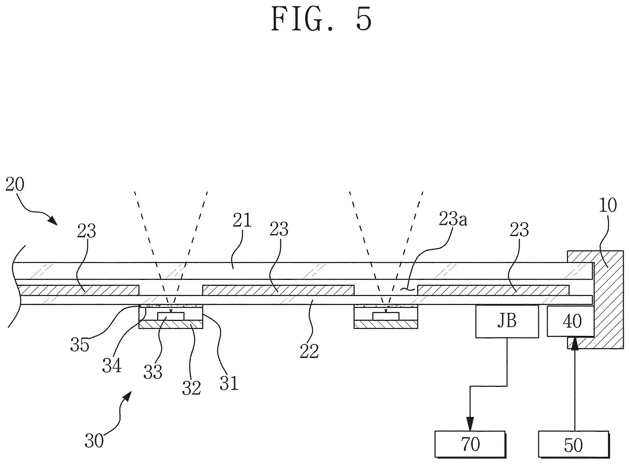

FIG. 1 is a schematic block diagram of a photovoltaic (PV) system capable of displaying images on the front according to an embodiment of the present invention, FIG. 2 is a perspective view of a structure of the PV system capable of displaying images on the front according to an embodiment of the present invention, FIG. 3 is an exploded view of the structure of the PV system capable of displaying images on the front according to an embodiment of the present invention, FIG. 4 is a front view of the structure of the PV system capable of displaying images on the front according to an embodiment of the present invention, and FIG. 5 is a schematic cross-sectional view of a state in which a light emitting diode (LED) module is adhered and fixed to a PV module according to an embodiment of the present invention.

Referring to FIGS. 1 to 5, the PV system capable of displaying images on the front according to an embodiment of the present invention may be installed on a building and includes a module frame 10, a PV module 20, LED modules 30, a module driver 40, a controller 50, and/or a battery 60 and an inverter 70.

The module frame 10 is a frame structure having the shape of a quadrangular frame that is installed on an outer wall of a building or in an opening of the outer wall to block an interior of the building from the outside.

A coupling groove (not illustrated) to which the PV module 20 is fitted and coupled, a junction box JB electrically connected to the PV module 20, the inverter 70 connected to the junction box JB, and a withdrawal passage (not illustrated) on which cables C1 are disposed may be formed at both side portions of the module frame 10.

The PV module 20 is a rectangular panel type structure that has both ends fitted and coupled to the module frame 10 having the shape of a quadrangular frame and is configured to collect PV energy and produce electricity. The PV module 20 includes a front cover 21, a back cover 22, and PV cells 23.

The front cover 21 is a plate type structure made of transparent glass or a synthetic resin material and is fixed to a front side of the module frame 10.

The back cover 22 is a plate type structure made of transparent glass or a synthetic resin material and is fixed to a rear side of the module frame 10 while maintaining a predetermined gap with the front cover 21.

The PV cells 23 are arranged in multiple stages while maintaining predetermined intervals therebetween for a light outlet 23a to be formed in the gap maintained between the front cover 21 and the back cover 22 and are electrically connected through the junction box JB and/or the inverter 70 and the cables C 1.

Here, the PV cell 23 may be a single side type cell or a double side type cell, and the cables C1 connected to the junction box JB and/or the inverter 70 electrically connected to the PV cell 23 may be connected by a cable jack J1.

Although not illustrated in the drawings, a protective sheet may be laminated on both sides of the PV cell 23, and the protective sheet may include particles containing ethylene vinyl acetate (hereinafter referred to as "EVA") as the main component.

The front cover 21 and the back cover 22 has been described above as being made of a transparent material but may also be made of a semi-transparent material or polymer material (for example, ethylene tetrafluoroethylene (ETFE) or the like). The front cover 21 delivers PV energy to the PV cell 23.

Although not illustrated in the drawings, a pattern part for expansion of a reflective area and a heat dissipation area may be formed on one side of the back cover 22. The pattern part may consist of embossed protrusions or may be a protruding structure bent in any one of a V-shape, an L-shape, a right-angled C-shape, and a U-shape.

When PV energy is collected by the PV cell 23 in the PV module 20, the back cover 22 may reflect some PV energy, which passes through the PV cell 23 without being collected, toward the PV cell 23. Accordingly, the amount of electricity production may be increased while PV energy collection performance of the PV cell 23 is improved. Therefore, the PV cell 23 may be formed to have a double-side cell structure rather than a single-side cell structure.

The LED modules 30 are disposed in multiple stages at the back cover 22 included in the PV module 20 and use the electricity produced by the PV module 20 as driving power to output light for an image to be displayed on the front of the PV module 20. The LED module 30 includes a lamp fixer 31, a substrate 32, LED devices 33, and a transparent cover window 34.

The lamp fixer 31 is adhered and fixed to the other side of the back cover 22 via a transparent adhesive layer 35 and has a box-shaped structure and opened in the direction of the PV module 20.

The substrate 32 is a flexible substrate fixed while accommodated in the lamp fixer 31.

The LED devices 33 are one or more LED chips mounted on the substrate 32 and are protected by the transparent cover window 34.

The transparent cover window 34 is coupled to the opening of the lamp fixer 31 and guides light to be output to the outside through the back cover 22, the light outlet 23a, and the front cover 21 while the LED devices 33 are turned on or are flickering.

The transparent adhesive layer 35 mentioned above is formed on the transparent cover window 34. The transparent adhesive layer 35 is for adhering and fixing the lamp fixer 31 to the other side of the back cover 22.

The transparent adhesive layer 35 may be a silicone adhesive or an adhesive sheet and may be formed on the transparent cover window 34 by a lamination technique or a hot press technique.

The transparent adhesive layer 35 may be made of an ethylene vinyl acetate (EVA) resin and may be formed on the transparent cover window 34, which is formed in the opening of the lamp fixer 31, by the hot press technique or the lamination technique.

The module driver 40 drives the LED modules 30 to be turned on, turned off, or flicker. Accordingly, the module driver 40 may include at least one board structure or one or more board structures that is or are attachable to and detachable from a side portion of the module frame 10 through a fastening member, and the board structure may be molded to be waterproof and dampproof. Although not illustrated in the drawings, a driving circuit including a direct current-direct current (DC-DC) converter may be mounted on the board structure.

The controller 50 outputs to the module driver 40 a signal for controlling whether the electricity produced by the PV module 20 is supplied or a driving pattern of turning-on, turning-off, or flickering of the LED modules 30. The controller 50 is connected to communicate with the module driver 40 through a wired or wireless communication network.

The battery 60 is mounted on the module frame 10. The battery 60 may be charged by the electricity produced by the PV module 20 and supply driving power to the LED module 30 and the module driver 40.

### [Modes of the Invention]

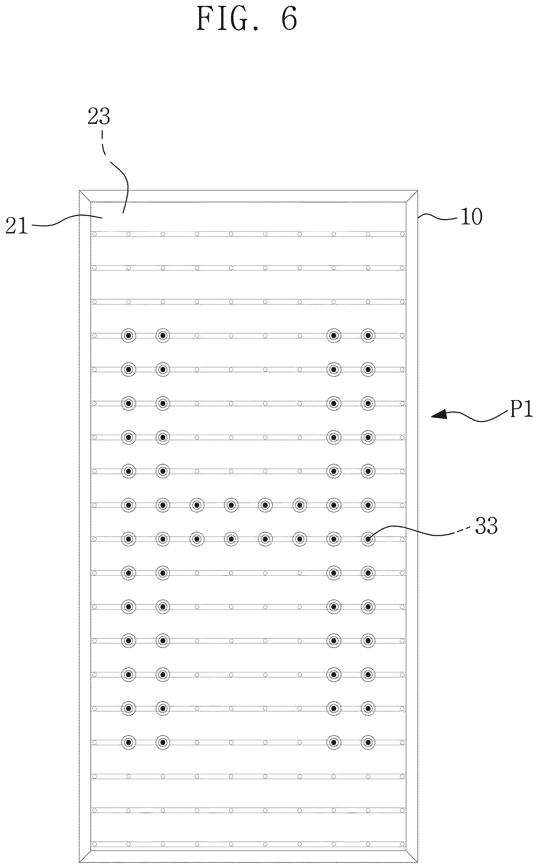

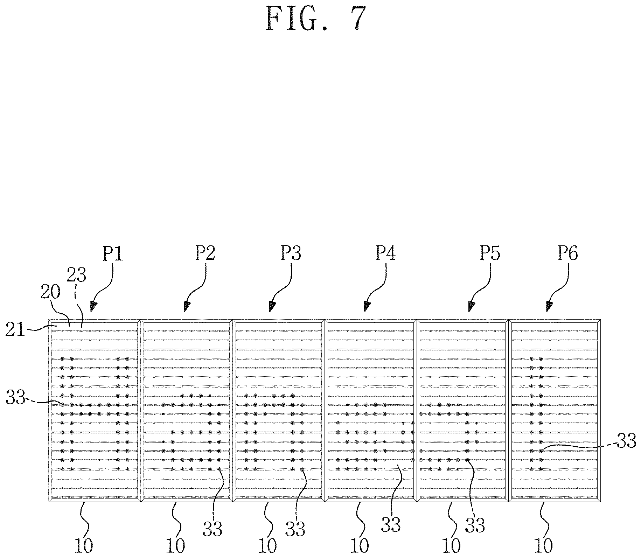

As in FIGS. 1 to 7, a photovoltaic (PV) system capable of displaying images on the front according to an embodiment of the present invention may be provided as a single PV system P1 on a building as in FIG. 6 or provided as a plurality of PV systems P1 to P6 continuously installed on a building using a single main frame as in FIG. 7.

Rectangular PV modules 20 provided as cell units that are arranged in multiple stages on the PV system P1 or each of the PV systems P1 to P6 collect PV energy and produce electricity. The produced electricity may be utilized as driving power of light emitting diode (LED) modules 30 and a module driver 40.

A controller 50 connected to communicate with the module driver 40 through a wired or wireless communication network sends to the module driver 40 a signal for controlling a driving pattern of turning-on, turning-off, or flickering of the LED modules 30 disposed in multiple stages. Then, the module driver 40 drives the LED modules 30 according to the control signal. Accordingly, images may be displayed on the single PV system P1 or the plurality of PV systems P1 to P6 according to the driving pattern of turning-on, turning-off, or flickering of LED devices 33.

That is, light generated due to turning-on or flickering of the LED devices 33 may transmit through a back cover 22 included in the PV module 20, pass through a light outlet 23a formed between PV cells 23, and then transmit through a front cover 21 again.

Light of the LED devices 33 that is output due to turning-on, turning-off, or flickering of the LED devices 33 according to the driving pattern control signal of the controller 50 does not affect PV energy collection by the PV cells 23. Accordingly, a predetermined still image or moving images that may be viewed by people from the outside may be displayed on a front side of the PV module 20.

The technical spirit of a PV system capable of displaying images on the front according to the present invention has been described above with reference to the accompanying drawings, but the above-described embodiments of the present invention are only illustrative and are not intended to limit the present invention.

Therefore, the present invention is not limited to specific exemplary embodiments described above. Those of ordinary skill in the art to which the invention pertains may make various modifications without departing from the gist of the present invention claims in the appended claims, and such modifications also belong to the scope of the claims.

### [Industrial Applicability]

According to the present invention, by efficient collection of photovoltaic (PV) energy through a PV module, electrical energy can be secured to increase the amount of power generation, and the secured electrical energy can be used to display various types of images on the outside of the building.

## Claims

1. A photovoltaic (PV) system capable of displaying images on the front, the PV system comprising:
a module frame fixed to a building;
a PV module mounted on the module frame and configured to collect PV energy and produce electricity;
light emitting diode (LED) modules disposed in multiple stages at a rear of the PV module and configured to use the electricity produced by the PV module as driving power to output light for an image to be displayed on a front of the PV module;
a module driver configured to drive the LED modules to be turned on, turned off, or flicker; and
a controller configured to output to the module driver a signal for controlling whether the electricity produced by the PV module is supplied or a driving pattern of turning-on, turning-off, or flickering of the LED modules.

2. The PV system of claim 1, wherein the PV module includes:
a transparent front cover fixed to the module frame;
a transparent back cover fixed to the module frame; and
PV cells arranged in multiple stages while maintaining predetermined intervals therebetween for a light outlet to be formed between the front cover and the back cover and electrically connected through a junction box and cables.

3. The PV system of claim 2, wherein a protective sheet is laminated on each of a front side and a rear side of the PV cell.

4. The PV system of claim 2, wherein the PV cell is a single side type cell or a double side type cell.

5. The PV system of claim 2, wherein the cables connected to the junction box electrically connected to the PV cell are connected by a cable jack.

6. The PV system of claim 2, wherein a pattern part for expansion of a reflective area and a heat dissipation area is formed on one side of the back cover.

7. The PV system of claim 6, wherein the pattern part consists of embossed protrusions.

8. The PV system of claim 7, wherein the pattern part is a protruding structure bent in any one of a V-shape, an L-shape, a right-angled C-shape, and a U-shape.

9. The PV system of claim 2, wherein the LED module includes:
a lamp fixer fixed to the other side of the back cover and formed in a box-shaped structure and opended in the direction of the PV module;
a substrate accommodated in the lamp fixer;
one or more LED devices mounted on the substrate; and
a transparent cover window coupled to the opening of the lamp fixer and configured to guide light caused by turning-on or flickering of the LED devices to be output to the outside through the back cover, the light outlet, and the front cover.

10. The PV system of claim 9, wherein the lamp fixer is adhered and fixed to the other side of the back cover by a transparent adhesive layer formed on the transparent cover window.

11. The PV system of claim 10, wherein the transparent adhesive layer is a silicone adhesive or an adhesive sheet.

12. The PV system of claim 11, wherein the transparent adhesive layer is formed on the transparent cover window by a lamination technique or a hot press technique.

13. The PV system of claim 1, wherein the module driver includes at least one board structure or one or more board structures that is or are attachable to and detachable from a side portion of the module frame through a fastening member, the board structure is molded to be waterproof and dampproof, and a driving circuit including a direct current-direct current (DC-DC) converter is mounted on the board structure.

14. The PV system of claim 13, wherein the controller is connected to communicate with the module driver.

15. The PV system of claim 1, wherein a battery configured to be charged by the electricity produced by the PV module and supply driving power to the LED module and the module driver is mounted on the module frame.
